# EUROPEAN PATENT APPLICATION

(11) **EP 4 556 294 A1**
(43) Date of publication of application: **21.05.2025**
(21) Application number: 22951057.3
(22) Date of filing: 12.07.2022
(51) Int. Cl.: B60L 15/00, H02M 7/48

(54) **CONTROL UNIT AND MOTOR DRIVE DEVICE FOR ELECTRICALLY DRIVEN VEHICLE, AND ELECTRICALLY DRIVEN VEHICLE**

(71) Applicant: Hitachi Industrial Products, Ltd., Tokyo 101-0021 (JP)
(72) Inventor: WAKABAYASHI, Yuichi, Tokyo 101-0021 (JP); TOUKAIRIN, Yoshikazu, Tokyo 101-0021 (JP)
(74) Representative: Mewburn Ellis LLP
(86) International application number: PCT/JP2022/027375
(87) International publication number: WO 2024/013841

(57) **Abstract**

Provided is a control unit for an electrically driven vehicle, in which thermal effects on a control board and the like is reduced, and heat dissipation is satisfactorily performed. A control unit (20) for an electrically driven vehicle receives an operation signal and signals from various sensors, and outputs control signals for left and right inverters that drive left and right motors connected to left and right wheels, respectively. The control unit (20) includes, in a box (21), a first interface board (25) on which at least an interface with a large amount of heat generation is mounted, a second interface board (26) on which an interface with a smaller amount of heat generation than the interface mounted on the first interface board is mounted, and a control board (24) for generating a control signal. The first interface board (25) is disposed higher than the second interface board (26) and the control board (24) in the box (21).

## Description

### TECHNICAL FIELD

The present invention relates to a control unit and a motor drive device for an electrically driven vehicle such as a dump truck, and to the electrically driven vehicle including the same.

### BACKGROUND ART

An electrically driven vehicle, which employs an electric drive method for a drive system, has been known as a vehicle such as a dump truck used in a mine, etc.

As an example, Patent Document 1 (WO 2019/163052 A1) describes "an electrically driven vehicle including an electric motor, an inverter that controls the electric motor, drive wheels driven by the electric motor, a brake resistor that consumes, as heat, electric power generated when the electric motor is regeneratively controlled in response to an operation of a retard pedal, a resistor temperature sensor that acquires a temperature of the brake resistor, a vehicle speed sensor that acquires a speed of a vehicle, and a controller that controls a speed of the electric motor using the inverter, wherein the controller includes a maximum speed calculation unit that calculates a maximum speed of the vehicle based on the temperature of the brake resistor acquired by the resistor temperature sensor, and controls the speed of the electric motor so that the maximum speed is not exceeded (see claim 1)".

### CITATION LIST

### PATENT DOCUMENT

Patent Document 1: WO 2019/163052 A1

### SUMMARY OF THE INVENTION

### PROBLEMS TO BE SOLVED BY THE INVENTION

The electrically driven vehicle includes a controller that receives input of operation signals from an accelerator pedal, a brake pedal, etc. and signals from various sensors such as a temperature sensor and outputs a control signal for controlling a speed of a motor connected to a drive wheel, and it is conceivable to accommodate a plurality of boards included in the controller in a box to form a unit. However, depending on the layout of the boards, a control board, etc. may be affected by heat from other boards, which may affect control characteristics.

In the "electrically driven vehicle" described in Patent Document 1, no consideration is given to unitizing the controller, nor to dissipating heat in the unit.

An object of the invention is to reduce thermal effects on a control board, etc. and to favorably dissipate heat in a control unit for an electrically driven vehicle.

### SOLUTIONS TO PROBLEMS

As an example of "a control unit for an electrically driven vehicle" of the invention for solving the above-mentioned problems,
a control unit for an electrically driven vehicle configured to receive input of an operation signal and signals from various sensors and to output control signals for left and right inverters configured to drive left and right motors connected to left and right wheels, respectively, includes a first interface board on which at least an interface having a large amount of heat generation is mounted, a second interface board on which an interface having a smaller amount of heat generation than the amount of heat generation of the interface mounted on the first interface board is mounted, and a control board configured to generate a control signal, in a box, wherein the first interface board is disposed higher than the second interface board and the control board in the box.

In addition, as an example of "a motor drive device for an electrically driven vehicle" of the invention,
a motor drive device for an electrically driven vehicle configured to receive input of alternating current (AC) power from a generator and output drive signals for left and right motors connected to left and right wheels, respectively, includes a rectifier unit configured to convert AC power from the generator into direct current (DC), a left motor inverter unit and a right motor inverter unit configured to create drive signals for the left and right motors, respectively, and a control unit configured to supply control signals to the left motor inverter unit and the right motor inverter unit, wherein the control unit includes a first interface board on which at least an interface having a large amount of heat generation is mounted, a second interface board on which an interface having a smaller amount of heat generation than the amount of heat generation of the interface mounted on the first interface board is mounted, and a control board configured to generate a control signal, in a box, and the first interface board is disposed higher than the second interface board and the control board in the box.

### EFFECTS OF THE INVENTION

According to the invention, by disposing an interface board on which an interface having a large amount of heat generation is mounted in an upper part in a box of a control unit, it is possible to reduce thermal effects on other boards and to favorably dissipate heat.

Problems, configurations, and effects other than those described above will become apparent from the following description of embodiments.

### BRIEF DESCRIPTION OF THE DRAWINGS

Fig. 1 is a side view of a dump truck of a first embodiment.
Fig. 2A is a cross-sectional view obtained by viewing a section A-A' of Fig. 1 from a front surface.
Fig. 2B is a cross-sectional view obtained by viewing a section B-B' of Fig. 1 from a rear surface.
Fig. 3 is a block diagram of a power system of the dump truck of the first embodiment.
Fig. 4 is a schematic block diagram of an electrical system including board layout in a control unit of the dump truck of the first embodiment.
Fig. 5 is a block diagram of a signal system of the dump truck of the first embodiment.
Fig. 6 is a perspective view of the control unit of the first embodiment.
Fig. 7 is a perspective view of another control unit of the first embodiment.
Fig. 8 is an explanatory diagram of a temperature sensor circuit using a thermistor.
Fig. 9 is a front view of a motor drive device of a second embodiment.

### MODE FOR CARRYING OUT THE INVENTION

Hereinafter, embodiments of the invention will be described with reference to the drawings. However, the invention should not be interpreted as being limited to the description of the embodiments illustrated below. It will be easily understood by those skilled in the art that a specific configuration can be changed without departing from the spirit or gist of the invention.

Note that, in the respective drawings for describing the embodiments, the same components are denoted by the same names and symbols as much as possible, and repeated descriptions thereof may be omitted.

### First embodiment

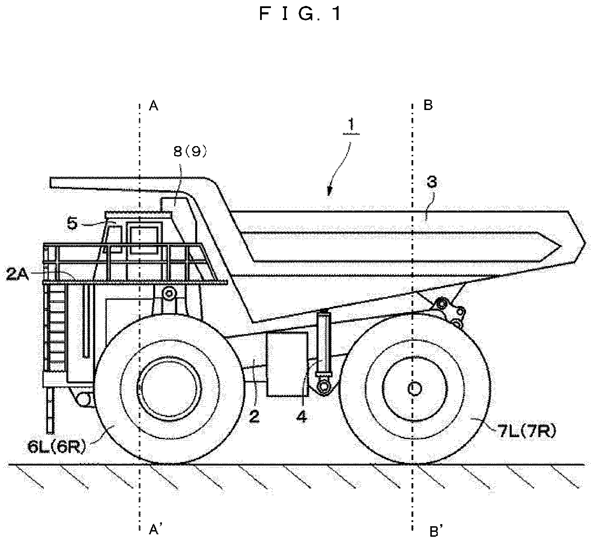

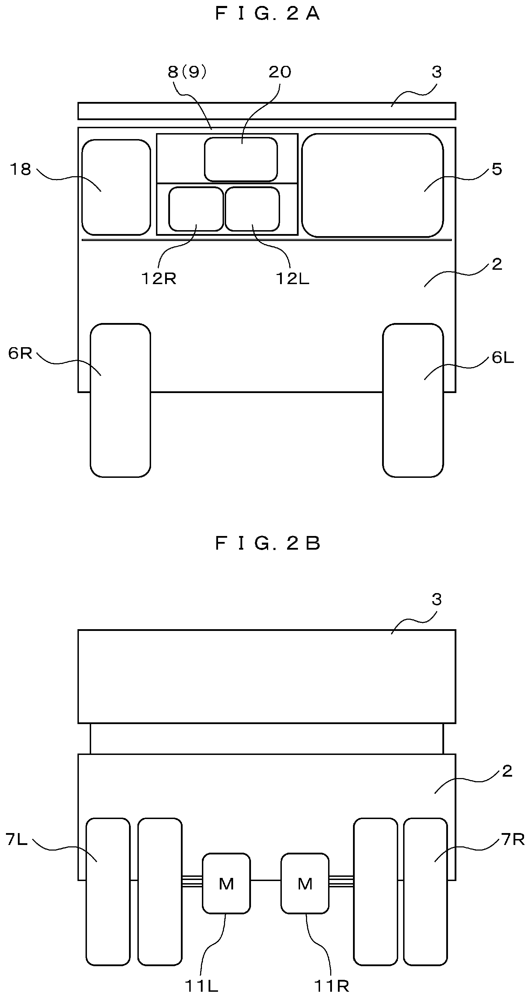

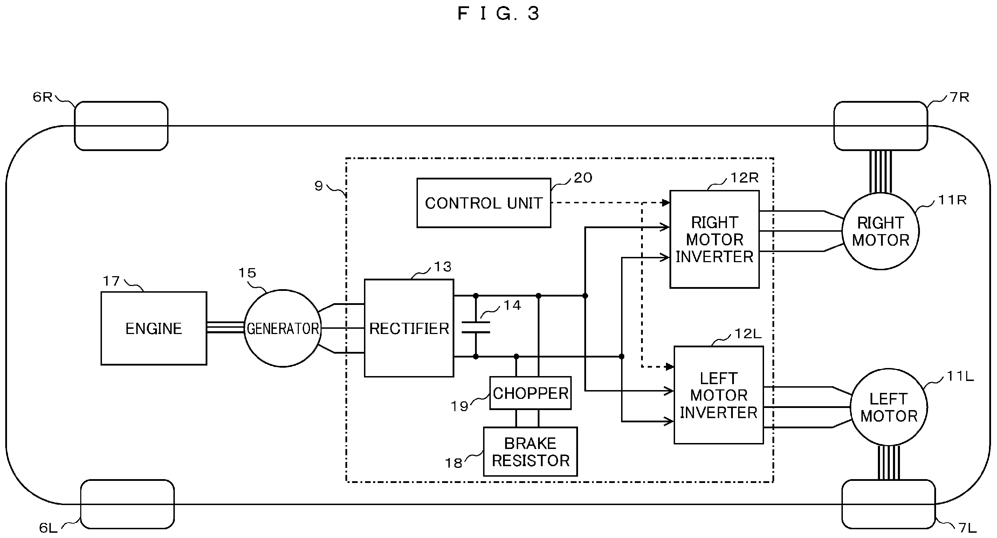

In this embodiment, the invention is used for a dump truck as an electrically driven vehicle. Fig. 1 is a side view of a dump truck of a first embodiment, Fig. 2A is a cross-sectional view obtained by viewing a section A-A' of Fig. 1 from a front surface, and Fig. 2B is a cross-sectional view obtained by viewing a section B-B' of Fig. 1 from a rear surface. In addition, Fig. 3 is a block diagram of a power system of the dump truck.

Left and right front wheels 6L and 6R are attached to a front side of a vehicle body 2 of the dump truck 1, and left and right rear wheels 7L and 7R are attached to a rear side of the vehicle body 2. A cabin (cab) 5 is provided at the front side of the vehicle body 2, and a driver can enter the cab 5 from a deck 2A at a front of the vehicle body 2. A control cabinet 8 is provided next to the cab 5, and a motor drive device 9, which will be described later, is accommodated therein. A tiltable cargo stand 3 for placing cargo such as ore thereon is provided at an upper rear side of the vehicle body 2, and the cargo such as ore loaded on the cargo stand 3 can be discharged by tilting the cargo stand 3 using a hoisting cylinder 4.

As illustrated in the cross-sectional view from the rear side of Fig. 2B, a left motor 11L and a right motor 11R are attached to the left and right rear wheels 7L and 7R, respectively. As illustrated in the cross-sectional view from the front side of Fig. 2A, the cab 5 is provided above the left and right front wheels 6L and 6R, and the control cabinet 8 and a brake resistor 18 are provided next to the cab 5. The control cabinet 8 accommodates a control unit 20, a right motor inverter unit 12R, a left motor inverter unit 12L, etc., which will be described later, to constitute the motor drive device 9.

Fig. 3 illustrates a schematic configuration diagram of the power system of the dump truck 1. This power system uses a diesel engine to drive a generator, converts generated AC power into DC, and drives an induction motor using an inverter.

When the dump truck 1 accelerates, a diesel engine 17 drives the generator 15 to generate three-phase AC power, and the AC power is converted into DC power by a rectifier (converter) 13 and a capacitor 14. Then, the DC power is supplied to the right motor inverter 12R and the left motor inverter 12L. The respective inverters are connected to the right motor 11R and the left motor 11L, which are induction motors, and the left and right rear wheels 7L and 7R are rotated by driving the induction motors using the inverters, causing the dump truck to move forward or backward.

When the dump truck 1 decelerates, the induction motors are operated as generators to convert kinetic energy of the vehicle body into electrical energy. The brake resistor 18 is connected to a DC circuit via a chopper 19. When a DC voltage exceeds a specified value, the chopper 19 is operated to connect to the brake resistor 18, so that the electrical energy is consumed as heat by the brake resistor 18. Then, the dump truck 1 decelerates.

Here, the DC voltage of the DC circuit is controlled by changing a rotation speed of the engine 17, and the left motor inverter 12L and the right motor inverter 12R are controlled by the control unit 20.

In addition, the rectifier 13, the inverters 12L and 12R, the control unit 20, etc. are included in the motor drive device 9.

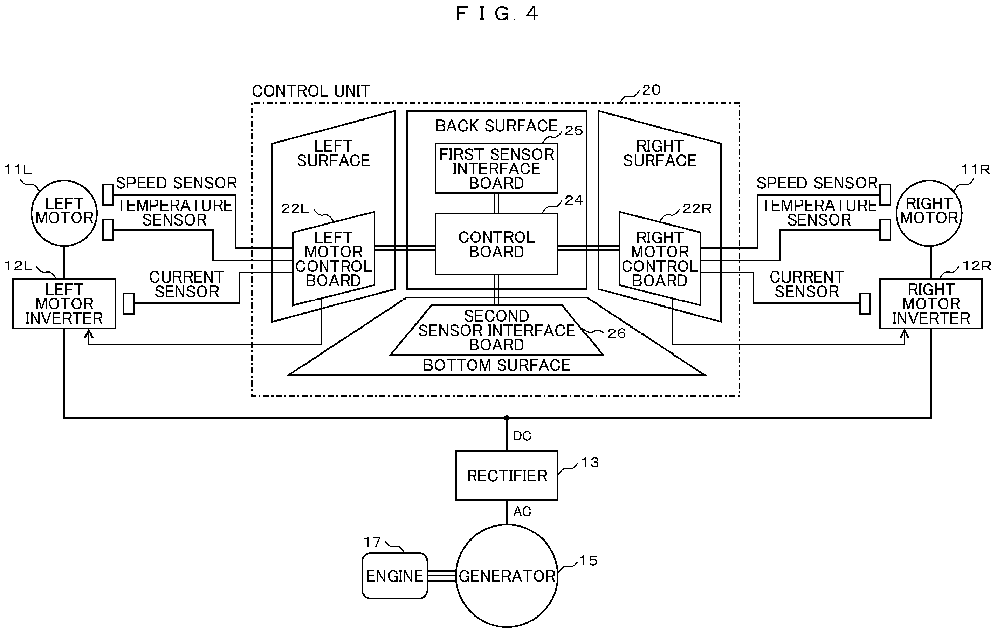

Fig. 4 illustrates a schematic block diagram of an electrical system of the dump truck including board layout in the control unit 20. As described above, the engine 17 drives the generator 15 to generate AC power, the AC power is converted into DC power by the rectifier 13, and the left and right motor inverters 12L and 12R drive the left and right motors 11L and 11R, respectively.

The control unit 20 includes a control board 24, a left motor control board 22L, a right motor control board 22R, and a plurality of sensor interface boards 25 and 26. The control unit 20 will be described in detail later.

Each of the left and right motors 11L and 11R includes a speed sensor and a temperature sensor, and each of the left and right motor inverters 12L and 12R includes a current sensor. Detection signals from the speed sensors, the temperature sensors, and the current sensors are input to the control unit 20, and based on these detection signals and signals from the control board 24, the left and right motor control boards 22L and 22R create control signals for the inverters (gate pulses, etc.). Then, the control signals are supplied to the left and right motor inverters 12L and 12R that drive the left and right motors 11L and 11R.

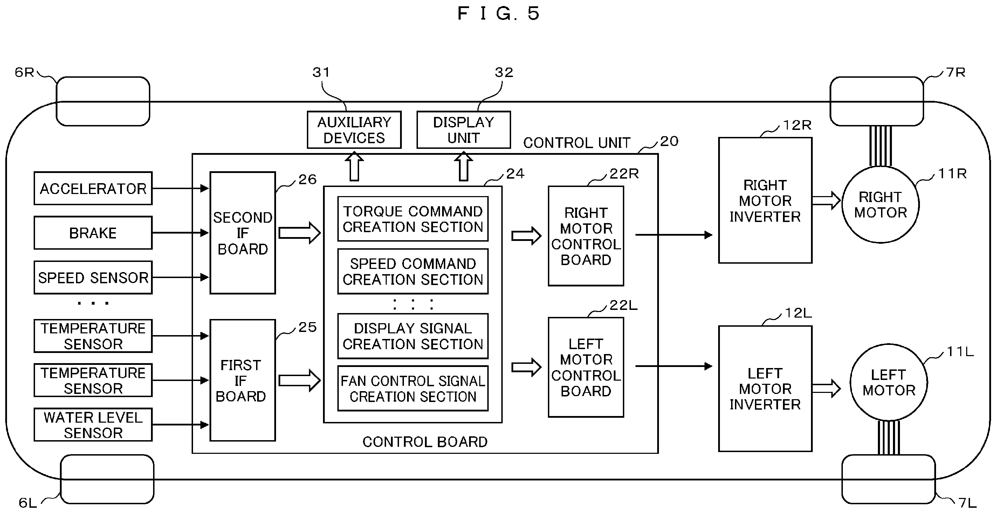

Fig. 5 is a block diagram of a signal system of the dump truck of this embodiment. Operation signals from an accelerator, a brake, etc., and detection signals from a speed sensor, various temperature sensors, a water level sensor for detecting a level of cooling water, etc. are input to the control unit 20. The temperature sensors include a temperature sensor for detecting temperatures of the left and right motors 11L and 11R, a temperature sensor for detecting temperatures of the left and right inverters 12L and 12R, a temperature sensor for detecting a temperature of cooling water, a temperature sensor for detecting a temperature of the brake resistor 18, a temperature sensor for detecting a temperature inside the control unit 20, etc.

In addition, the dump truck has a display unit 32 that displays a driving condition such as speed and an alarm when an abnormality is detected in the cab 5, and includes various auxiliary devices 31 such as cooling fans. The cooling fans are provided as necessary at locations that generate heat, such as the left and right motors 11L and 11R, the brake resistor 18, inside the control cabinet 8, etc.

The control board 24 includes a microcomputer, and, for example, is provided with a torque command creation section and a speed command creation section that create control signals supplied to the left and right motor control boards, an abnormality detection section that detects abnormalities from a detection signal, a display signal creation section that creates a display signal supplied to the display unit, a fan control signal creation section that creates a control signal for a cooling fan, which is an auxiliary device, etc.

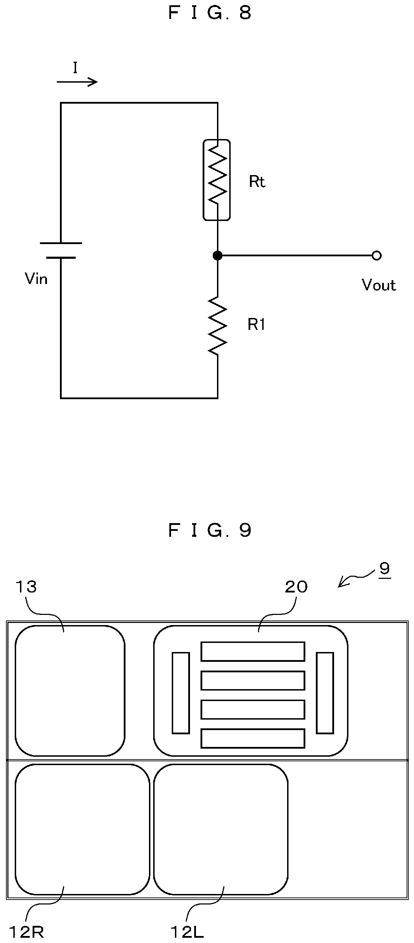

Here, a temperature sensor using a thermistor will be described. Fig. 8 illustrates an example of a temperature detection circuit using a thermistor. A DC power source Vin is connected to a series circuit of a thermistor Rt and a resistor R1, and a detection current I is supplied. Since a resistance value of the thermistor changes depending on the temperature, the temperature can be detected by detecting a voltage Vout at a connection point between the thermistor Rt and the resistor R1. In this way, the detection current I needs to be supplied in temperature detection using the thermistor, and an interface to which the thermistor is connected as a detection element generates heat due to the detection current. Then, there is concern that heat generated in an interface board equipped with the interface to which the thermistor is connected may have thermal effects on another board such as a control board, causing characteristics to become unstable. Note that the thermistor is also used for a water level sensor.

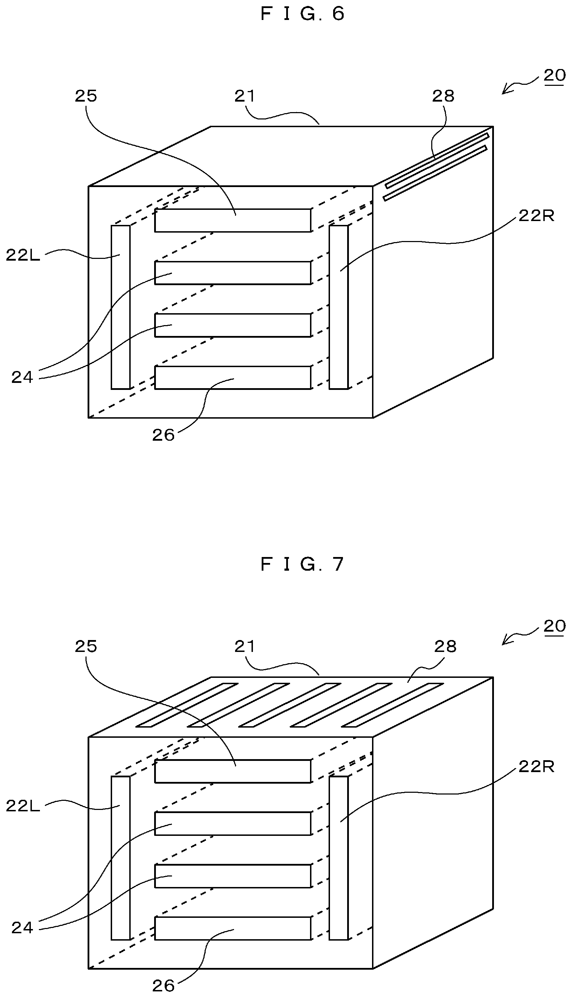

As a characteristic configuration of this embodiment, as illustrated in Fig. 6, a first sensor interface board 25 equipped with an interface that generates a lot of heat, such as a temperature sensor, and a second sensor interface board 26 equipped with an interface that generates less heat, such as a speed sensor, are provided inside a box 21, and arrangement of the first interface board and the second interface board is devised.

Fig. 6 illustrates an example of the control unit 20 incorporating various boards. The first sensor interface board 25 equipped with the interface that generates a lot of heat, such as the temperature sensor, is disposed in an upper part of box 21. Then, the control board 24 and the second sensor interface board 26 equipped with the interface that generates less heat, such as the speed sensor, are disposed below the first sensor interface board 25. In the example illustrated in the figure, the second sensor interface board 26 is disposed below the control board 24. Here, the interface that generates a lot of heat is an interface that supplies detection current to the connected sensor and is, for example, an interface to which a thermistor, which is a temperature sensor, is connected. In addition, a vent 28 is provided in an upper part of a side plate of the box 21.

By disposing the first sensor interface board 25, which is equipped with the interface that generates a lot of heat, in the upper part of the box 1, heat generated from the first sensor interface board 25 is directed toward the upper part of box 21 and dissipated from the vent 28, etc., so that it is possible to reduce thermal effects on other boards such as the control board.

As another characteristic configuration of this embodiment, as illustrated in Fig. 6, the left motor control board 22L and the right motor control board 22R are disposed laterally evenly on the left and right sides of the box 21. Specifically, the left motor control board 22L and the right motor control board 22R are symmetrically disposed on the left and right sides with respect to a center line of the box 21. By laterally evenly disposing the left motor control board 22L and the right motor control board 22R, it is possible to reduce temperature deviation, and to reduce deviations in characteristics of the left and right motor control due to temperature changes.

Note that, although not illustrated in the figure, if necessary, a cooling fan may be provided to supply cooling air into the box 21. In addition, a temperature sensor may be provided to detect a temperature inside the box 21, and the cooling fan may be controlled according to a temperature detected by the temperature sensor.

Fig. 7 illustrates a modified example of the control unit 20. In this modified example, a plurality of vents 28 is provided on an upper surface (top plate) of the box 21. By providing the plurality of vents 28 on the upper surface of the box 21, heat generated in the first sensor interface board 25 can be efficiently dissipated.

According to this embodiment, in the control unit for the electrically driven vehicle, when the first sensor interface board equipped with the interface that generates a lot of heat is disposed higher than the control board and the second sensor interface board equipped with the interface that generates less heat than that of the interface mounted on the first sensor interface board in the box, heat generated from the first sensor interface board is directed toward the upper part of the box and dissipated from the vent, etc., and thus it is possible to reduce thermal effects on other boards such as the control board.

In addition, by disposing the left motor control board and the right motor control board laterally evenly on the left and right sides of the box, respectively, it is possible to reduce temperature deviation, and to reduce deviations in characteristics of the left and right motor control due to temperature changes.

### Second embodiment

Fig. 9 illustrates a motor drive device of a second embodiment of the invention. The motor drive device of this embodiment is a motor drive device for an electrically driven vehicle that receives input of AC power from a generator and outputs drive signals for left and right motors connected to left and right wheels, respectively, and is a combination of respective units included in the motor drive device.

As illustrated in Fig. 9, the motor drive device includes a left motor inverter unit 12L and a right motor inverter unit 12R that create drive signals for the left and right motors, respectively, a rectifier unit 13 that converts AC power from the generator into DC power, and the control unit 20 of the first embodiment that supplies control signals to the left motor inverter unit and the right motor inverter unit. Further, as illustrated in Fig. 2A, the respective units included in a motor control device 9 are accommodated in the control cabinet 8 of the dump truck.

In each of the embodiments, the invention has been described as being used for the dump truck. However, the invention may be used for other electrically driven vehicles.

Note that the invention is not limited to the above-mentioned embodiments, and includes various modified examples. For example, the above-mentioned embodiments have been described in detail to clearly describe the invention, and the invention is not necessarily limited to those having all of the described configurations. In addition, with respect to a part of a configuration of each embodiment, another configuration may be added, deleted, or replaced.

### REFERENCE SIGNS LIST

- 1: Dump truck
- 2: Vehicle body
- 2A: Deck
- 3: Cargo stand
- 4: Hoisting cylinder
- 5: Cabin (cab)
- 6L, 6R: Front wheel
- 7L, 7R: Rear wheel
- 8: Control cabinet
- 9: Motor drive device
- 11L: Left motor
- 11R: Right motor
- 12L: Left motor inverter
- 12R: Right motor inverter
- 13: Rectifier (converter)
- 14: Capacitor
- 15: Generator
- 17: Engine
- 18: Brake resistor
- 19: Chopper
- 20: Control unit
- 21: Box
- 22L: Left motor control board
- 22R: Right motor control board
- 24: Control board
- 25: First sensor interface board
- 26: Second sensor interface board
- 28: Vent
- 31: Auxiliary devices
- 32: Display unit

## Claims

1. A control unit for an electrically driven vehicle configured to receive input of an operation signal and signals from various sensors and to output control signals for left and right inverters configured to drive left and right motors connected to left and right wheels, respectively, the control unit comprising:
a first interface board on which at least an interface having a large amount of heat generation is mounted, a second interface board on which an interface having a smaller amount of heat generation than the amount of heat generation of the interface mounted on the first interface board is mounted, and a control board configured to generate a control signal, in a box,
wherein the first interface board is disposed higher than the second interface board and the control board in the box.

2. The control unit for the electrically driven vehicle according to claim 1, wherein the interface mounted on the first interface board supplies current to a connected sensor.

3. The control unit for the electrically driven vehicle according to claim 2, wherein the interface mounted on the first interface board is an interface connected to a temperature sensor.

4. The control unit for the electrically driven vehicle according to claim 3, wherein the temperature sensor is a thermistor.

5. The control unit for the electrically driven vehicle according to claim 1, wherein a left motor control board and a right motor control board are laterally evenly disposed on left and right sides of the box, respectively.

6. The control unit for the electrically driven vehicle according to claim 1, wherein vents are provided in upper parts of left and right side walls of the box or on an upper surface of the box.

7. A motor drive device for an electrically driven vehicle configured to receive input of alternating current (AC) power from a generator and output drive signals for left and right motors connected to left and right wheels, respectively, the motor drive device comprising:
a rectifier unit configured to convert AC power from the generator into direct current (DC);
a left motor inverter unit and a right motor inverter unit configured to create drive signals for the left and right motors, respectively; and
a control unit configured to supply control signals to the left motor inverter unit and the right motor inverter unit, wherein:
the control unit includes a first interface board on which at least an interface having a large amount of heat generation is mounted, a second interface board on which an interface having a smaller amount of heat generation than the amount of heat generation of the interface mounted on the first interface board is mounted, and a control board configured to generate a control signal, in a box, and
the first interface board is disposed higher than the second interface board and the control board in the box.

8. The motor drive device for the electrically driven vehicle according to claim 7, wherein the interface mounted on the first interface board of the control unit supplies current to a connected sensor.

9. The motor drive device for the electrically driven vehicle according to claim 8, wherein the interface mounted on the first interface board of the control unit is an interface connected to a thermistor.

10. The motor drive device for the electrically driven vehicle according to claim 7, wherein a left motor control board and a right motor control board are laterally evenly disposed on left and right sides of the box of the control unit, respectively.

11. The motor drive device for the electrically driven vehicle according to claim 7, wherein vents are provided in upper parts of left and right side walls of the box of the control unit or on an upper surface of the box.

12. The motor drive device for the electrically driven vehicle according to claim 7, wherein the rectifier unit, the left motor inverter unit, the right motor inverter unit, and the control unit are accommodated in a control cabinet of the electrically driven vehicle.

13. An electrically driven vehicle comprising:
left and right motors connected to left and right wheels, respectively; and
the motor drive device according to claim 7.

14. The electrically driven vehicle according to claim 13, further comprising:
a generator configured to generate AC power; and
an engine configured to drive the generator.

15. The electrically driven vehicle according to claim 13, wherein the electrically driven vehicle is a dump truck.
